(19) Europäisches Patentamt European Patent Office Office européen des brevets

(11) **EP 4 375 680 A1**

(12) **EUROPÄISCHE PATENTANMELDUNG**

(43) Veröffentlichungstag:
**29.05.2024 Patentblatt 2024/22**

(21) Anmeldenummer: **22209307.2**

(22) Anmeldetag: **24.11.2022**

(51) Internationale Patentklassifikation (IPC):
***G01R 19/25*** *(2006.01)*

(52) Gemeinsame Patentklassifikation (CPC):
**G01R 19/2513; G06N 3/04; G06N 3/084;**
G01R 31/40

(84) Benannte Vertragsstaaten:
**AL AT BE BG CH CY CZ DE DK EE ES FI FR GB
GR HR HU IE IS IT LI LT LU LV MC ME MK MT NL
NO PL PT RO RS SE SI SK SM TR**
Benannte Erstreckungsstaaten:
**BA**
Benannte Validierungsstaaten:
**KH MA MD TN**

(71) Anmelder: **Siemens Aktiengesellschaft
80333 München (DE)**

(72) Erfinder: **Troyer, Markus
3040 Neulengbach (AT)**

(74) Vertreter: **Siemens Patent Attorneys
Postfach 22 16 34
80506 München (DE)**

(54) **VERFAHREN ZUR ERKENNUNG VON PARALLELSCHALTUNGEN IN
STROMVERSORGUNGSEINRICHTUNGEN**

(57)    Die Erfindung betrifft ein Verfahren zur Erkennung von Parallelschaltungen von Ausgangskanälen in Stromversorgungseinrichtungen, bei dem zur Erkennung der Parallelschaltungen ein in einem ersten Digitalrechner einer Überwachungseinrichtung implementiertes neuronales Netz vorgesehen ist, wobei zur Ermittlung von Trainingsdaten ($UCh1[0]$ $UCh2[1]$ $UCh1[2]$ ***UCh2[3]*** ... ***UCh1[j-3]*** ***UCh2[j-2]*** ***UCh1[j-1]*** ***UCh2[j]***) für das neuronale Netz in einer Stromversorgungseinrichtung verschiedene Betriebszustände ausgelöst und die dazugehörigen Spannungsverläufe und/oder Stromverläufe an den Ausgangskanälen gemessen werden, wobei die Trainingsdaten an einen weiteren Digitalrechner übermittelt werden mittels welchem das Training des neuronalen Netzes erfolgt und wobei das trainierte einsatzbereite neuronale Netz in den ersten Digitalrechner der Überwachungseinrichtung implementiert und zur Erkennung von Parallelschaltungen herangezogen wird.

FIG 3

EP 4 375 680 A1

**Beschreibung**

Die Erfindung betrifft ein Verfahren zur Erkennung von Parallelschaltungen, insbesondere in Stromversorgungseinrichtungen

Die Vorteile von elektronischen Sicherungen im Bereich industrieller Gleichspannungsversorgungen gegenüber herkömmlichen Schmelzsicherungen oder elektromagnetischen Auslösern führen zu einer zunehmenden Verbreitung dieser Sicherungen.

Mit der steigenden Leistungsfähigkeit dieser Gleichspannungsversorgungen steigen auch die Anforderungen an die Sicherungen.

Eine besondere Herausforderung stellt dabei der Parallelbetrieb von Kanälen der Stromversorgungen dar, wie er zur Erhöhung der Ausgangsleistung üblich ist. Verschiedene Betriebssituationen wie Kanalhochlauf, Überstrombegrenzung, Abschaltung, Sollwertvorgabe etc. müssen auf den Parallelbetrieb abgestimmt werden.

Durch eine selbsttätige Erkennung einer Parallelschaltung von Kanälen kann die Überwachungseinrichtung dies entsprechend frühzeitig erkennen und sich darauf einstellen.

Die EP2812969 B1 beschreibt den Betrieb von Stromversorgungen mit parallelschaltbaren Ausgängen. Dabei werden verschiedene Verfahren vorgeschlagen, um festzustellen, ob zwei oder mehr Ausgangskanäle parallelgeschaltet wurden. Eine erste Methode umfasst eine Kontaktierungsklammer, die mittels eines eingebauten Schalters oder anderen elektronischen Kontakts der Überwachungseinrichtung die Parallelschaltung signalisiert und gleichzeitig den Leistungskontakt herstellt.

Ferner wird eine Methode beschrieben, bei der im Gerätehochlauf eine Testsequenz durchgeführt wird. Durch kurzzeitiges Einschalten eines Ausgangskanals und gleichzeitiges Messen der Ausgangsspannung am aktivierten Kanal und dessen Nachbarkanälen kann über einen Vergleich der Messdaten festgestellt werden, ob eine Parallelschaltung vorliegt.

Steigt die Ausgangsspannung gleichzeitig am aktivierten und an einem inaktiven Kanal, wird eine Parallelschaltung erkannt.

Im Betrieb lässt sich durch die Stromregelung der Stromversorgung eine Parallelschaltung erkennen. Teilen sich bspw. zwei Ausgangskanäle einen Laststrom, lässt sich dies in zweierlei Arten messtechnisch ermitteln. Durch Reduktion des Sollwerts an einem den beiden Kanälen wird bei Unterschreiten des Sollwerts unter den momentan fließenden Laststrom der Stromregler aktiv. Dadurch wird der Strom durch diesen Kanal in die Last reduziert. Entweder übernimmt der benachbarte Kanal den Stromfluss, wodurch die Parallelschaltung durch die Summierung der Ströme erkannt werden kann, oder durch die Reduktion sinkt die Ausgangsspannung an beiden Kanälen, wodurch die Parallelschaltung wiederum über die Ausgangsspannungsüberwachung erkannt wird.

Nachteilig ist an der beschriebenen Lösung vor allem die aufwändige Implementierung.

Der Erfindung liegt die Aufgabe zugrunde, ein Verfahren anzugeben, mit dem die Erkennung von Parallelschaltungen verbessert wird.

Erfindungsgemäß geschieht dies mit einem Verfahren zur Erkennung von Parallelschaltungen von Ausgangskanälen in Stromversorgungseinrichtungen, bei dem zur Erkennung der Parallelschaltungen ein in einem ersten Digitalrechner einer Überwachungseinrichtung implementiertes neuronales Netz vorgesehen ist, bei dem zur Ermittlung von Trainingsdaten für das neuronale Netz in einer Stromversorgungseinrichtung verschiedene Betriebszustände ausgelöst und die dazugehörigen Spannungsverläufe an den Ausgangskanälen gemessen werden, dass die Trainingsdaten an einen weiteren Digitalrechner übermittelt werden mittels welchem das Training des neuronalen Netzes erfolgt und dass das trainierte einsatzbereite neuronale Netz in den ersten Digitalrechner der Überwachungseinrichtung implementiert und zur Erkennung von Parallelschaltungen herangezogen wird. Vorteilhafte Ausgestaltungen ergeben sich aus den Unteransprüchen.

In klassischen Programmierparadigmen werden die Regeln einer informationstechnischen Problemstellung im Vorenherein definiert und anschließend im Sourcecode durch Entscheidungsbäume, bspw. durch if{}-else{} Anweisungen implementiert. Die Herausforderung liegt hierbei in der Erfassung möglichst aller möglichen Zustände in ein einheitliches Regelwerk. Dieses Regelwerk ist entsprechend starr und kann sich nur schwer an sich ändernde Gegebenheiten anpassen, die nicht im Voraus berücksichtigt wurden.

Künstliche neuronale Netze (engl. Artificial Neuronal Networks, kurz ANN) bieten hierfür einen anderen, problemlösungsorientierten Ansatz. Die informationstechnische Problemstellung wird abstrahiert (Modellbildung) und durch einen Lernvorgang wird die Regelfindung dem Modell selbst überlassen.

Während dieses Lernvorganges werden dem Modell zuvor messtechnisch ermittelte Datensätze als Eingangsparameter und die zugehörigen Kategorien als Ausgangsparameter des Modells zur Verfügung gestellt.

Durch statistische Optimierungsverfahren wird versucht die Eingangsdaten auf diese Ausgangsdaten abzubilden. Auf die Problemstellung der Parallelschaltung bezogen, werden vor dem Lernvorgang Versuchsreihen durchgeführt, bei denen verschiedene Lastbedingungen mit und ohne Parallelschaltung berücksichtigt wurden. Diese Messdaten dienen als Basis für die Eingangsdaten des Modells, die Kategorisierung "Parallel" oder "Single" als Ausgangsparameter.

Nach dem Durchlaufen des Lernvorganges samt anschließender Validierung und Test des neuronalen Netzes, erhält man ein trainiertes Modell als Ergebnis, das auf die Überwachungseinrichtung wie beispielsweise einen Mikrocontroller übertragen wird und dort im Rahmen der sogenannten "Inferenz" verwendet wird.

Die Erfindung wird anhand von Figuren näher erläutert. Es zeigen beispielhaft:

Fig.1a, 1b erste Trainingsdatensätze
Fig.2a, 2b zweite Trainingsdatensätze
Fig.3 die Topologie eines neuronalen Netzes
Fig.4 einen Ablauf des erfindungsgemäßen Verfahrens zur Erkennung von Parallelschaltungen
Fig.5 Ablauf des erfindungsgemäßen Verfahrens integriert in den Gerätehochlauf
Fig.6 Ablauf des erfindungsgemäßen Verfahrens unter Verwendung des Stromverlaufs

Bei dem erfindungsgemäßen Verfahren werden in einem ersten Schritt für den Lernvorgang des neuronalen Netzes zunächst Trainingsdaten gesammelt. Dazu werden mittels der Überwachungseinrichtung der Stromversorgung, typischerweise einem Mikrocontroller, verschiedene Betriebszustände ausgelöst, d.h. Versuchsreihen mit verschiedenen Lastbedingungen mit und ohne Parallelschaltung durchgeführt und die Ausgangsspannungsverläufe $U_{outCh1}$, $U_{outCh2}$ oder ggf. die Stromverläufe an den Kanälen gemessen.

Der Begriff der Stromversorgung umfasst dabei Netzteile und/oder elektronische Sicherungen und/oder eine Kombination der beiden verstehen.

Die gemessenen Werte werden mittels Analog-Digital-Konverter digitalisiert Scan ADC und in einen Pufferspeicher geschrieben. Durch die Speichergröße des Puffers, bspw. n = 200Sample, und die Konvertierungszeit des Analog-Digital-Konverters, kann die Scandauer auf die Testsequenz abgestimmt werden.

Vorzugsweise werden die Ausgangsdaten des Analog-Digital-Konverters über sogenannten Direct Memory Access direkt in den Speicher geschrieben, ohne dass dabei der Rechenkern der Überwachungseinrichtung bzw. des Mikrocontrollers belastet wird.

Beim Ausführungsbeispiel werden die Testdaten von der Überwachungseinrichtung gemessen. Es kann aber unter bestimmten Voraussetzungen zweckmäßig sein, diese Messung der Testdaten und die Bildung des Eingangstensors für das neuronale Netz von einer eigenen Hardware durchführen zu lassen.

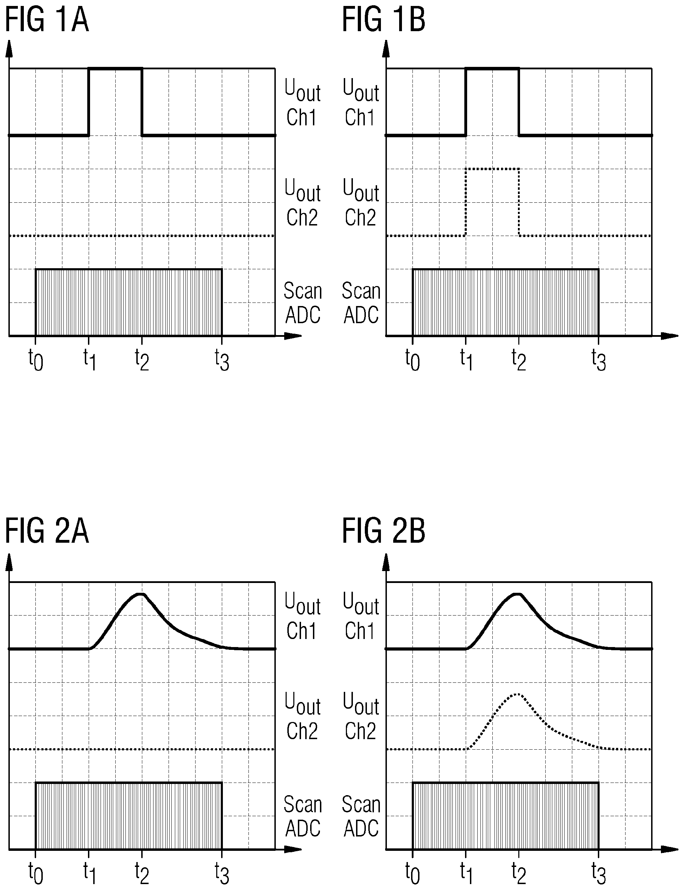

Ein beispielhaftes Lastmuster, wie es in den Fig. 1a für unabhängige Kanäle und in Fig. 1b für parallel geschaltete Ausgangskanäle dargestellt ist, umfasst einen Testimpuls an einem ersten Kanal der Stromversorgung im Zeitraum t1 bis t2. Dieser soll zeitlich so begrenzt sein, dass die dahinterliegende Last nicht ungewollt anspringt.

Typische Werte hierfür sind einige 100ps.

Da davon auszugehen ist, dass nicht ausschließlich lineare Lasten an die Stromversorgung angeschlossen werden, sondern auch solche, die anschließend einen Ausgleichsvorgang aufweisen, verläuft der Messvorgang über die Impulsdauer hinaus bis zum Zeitpunkt t3, sodass Abklingvorgänge zumindest teilweise erfasst werden können.

Danach liegen die abgetasteten Messdaten der betrachteten Ausgangskanäle, beispielsweise n - Abtastwerte abwechselnd für beide Kanäle im Speicher (mit steigender Speicheradresse) des Mikrocontrollers vor

$$\langle UCh1[0] \quad UCh2[0] \quad UCh1[1] \quad UCh2[1] \quad ... \quad UCh1[n-1] \quad UCh2[n-1] UCh1[n] \quad UCh2[n] \rangle$$

Diese Anordnung ist von der Konfiguration des Mikrocontrollers und der Messkanäle abhängig.

Der Index n beziffert die diskreten Abtastzeitpunkte des Analog-Digital-Konverter. Die Zahl der Abtastzeitpunkte und die Anzahl der zu erfassenden Kanäle bestimmen die Größe des erforderlichen Speichers und auch die Reihenfolge der Daten im Speicher.

Mit j als Index der Speicheradresse werden die Messwerte wie folgt im Speicher abgebildet:

$$\langle UCh1[0] UCh2[1] UCh1[2] UCh2[3] ...UCh1[j-3] UCh2[j-2]UCh1[j-1] UCh2[j] \rangle$$

Denkbar wäre auch eine Abtastung der Ausgangsspannungen mit mehreren Analog-Digital-Konvertern und Abspeicherung der Daten in unterschiedlichen Speicherbereichen.

Die korrekte, übereinstimmende Anordnung und Reihenfolge der Daten sowohl im Training als auch im Betrieb ist wesentlich für den erfolgreichen Einsatz, die Inferenz, des neuronalen Netzes. Abweichungen müssen daher rechtzeitig korrigiert werden.

Sind die Voraussetzungen geschaffen, kann die Testsequenz mehrmals durchlaufen werden. Dabei werden zunächst Datensätze gesammelt, bei denen die Kanäle sowohl parallelgeschaltet als auch einzeln betrieben wurden. Durch den Signalverlauf der Ausgangsspannungen erhält man dadurch unterschiedliche Datensätze für Einzelkanäle Fig. 1.a, Fig. 2a als auch für ParallelschaltungFig.1b, Fig. 2b.

Um das neuronale Netz von vornherein auf unterschiedliche Lastsituationen zu trainieren, ist es sinnvoll die Wiederholungen mit wechselnden Lasten durchzuführen. Rein ohmsche Lasten haben einen annähernden Spannungsverlauf gemäß Fig. 1a, 1b. Bei Lasten mit kapazitivem Anteil steigt die Ausgangsspannung mit Verzögerung, und wird dabei verschliffen und ggf. zeitversetzt, wie es in den Fig. 2a, 2b dargestellt ist. Des Weiteren ist es auch sinnvoll die Eingangsspannung der elektronischen Sicherung zu variieren, um den gesamten Betriebsspannungsbereich abzudecken.

Für optimale Trainingsergebnisse erfolgt die Variation der genannten Parameter vorzugsweise zufällig.

Das Training des neuronalen Netzes und die Vorverarbeitung der Daten erfolgen vorzugsweise nicht im ersten Digitalrechner der Überwachungseinrichtung, sondern mittels eines davon unabhängigen weitern Digitalrechners, beispielsweise eines handelsüblichen Personal Computers.

Die von der Überwachungseinrichtung gemessenen Testdaten werden daher auf diesen Personal Computer übertragen und einer Vorverarbeitung unterzogen.

Dabei werden diese Testdaten zunächst kategorisiert, im Beispiel durch "Parallel" und "Single".

Zweckmäßig ist auch eine Normierung der Rohdaten auf den Wert 1024 ($2^{10}$) und eine Bearbeitung auf Gleitkommabasis.

Anschließend werden die normierten Rohdaten in einen Tensor - eine Matrix - geschrieben und bilden den sog. Eingangstensor.

Werden beispielsweise n-Samples für jeden Durchlauf der Testsequenz aufgenommen und der Durchlauf k-mal wiederholt (k-Records) ergibt sich eine Matrix der Gestalt [k,i] mal wiederholt (k-Records) ergibt sich eine Matrix der Gestalt [k,i].

$$\begin{bmatrix} U^0_{Ch1}[0] & U^0_{Ch2}[0] & \dots & U^0_{Ch1}[n-1] & U^0_{Ch2}[n-1] & U^0_{Ch1}[n] & U^0_{Ch2}[n] \\ \vdots & \vdots & \dots & \vdots & \vdots & \vdots & \vdots \\ U^k_{Ch1}[0] & U^k_{Ch2}[0] & \dots & U^k_{Ch1}[n-1] & U^k_{Ch2}[n-1] & U^k_{Ch1}[n] & U^k_{Ch2}[n] \end{bmatrix}$$

Da zwei Kanäle zu den diskreten Zeitpunkten n gesampelt werden, muss der Buffer die Dimension j haben, wobei gilt

$$j = 2n$$

Da zum Zeitpunkt der Datenerfassung bekannt ist, ob die Ausgangskanäle parallelgeschaltet waren, können den einzelnen Zeilen der Matrix mit "Parallel" oder "Single" Kategorien zugeordnet werden. Diese Kategorien müssen numerisch abgebildet werden. Dieser Prozess wird als "Hot Encoding" bezeichnet.

Die numerische Darstellung ist Teil der Problemabstraktion und ist für den Algorithmus zur Regelfindung notwendig. Das Hot Encoding ist eine einfache numerische Zuweisung

$$\begin{bmatrix} 1 & 0 \\ 0 & 1 \end{bmatrix} = \begin{bmatrix} Parallel \\ Single \end{bmatrix}$$

Damit kann dem neuronalen Netz zum Training der Eingangstensor bestehend aus den Testdaten und der Zuweisung des Zustands "Parallel" oder "Single" übergeben werden. Der Eingangstensor hat dabei eine Dimension [k, j] und durch die zeilenweise Zuweisung des Zustands ergibt sich wiederum eine Matrix der Gestalt [k, 2]. Diese Matrix wird als Ausgangstensor bezeichnet.

Neuronale Netze basieren meist auf der Vernetzung vieler McCulloch-Pitts-Neuronen oder leichter Abwandlungen davon. Grundsätzlich können auch andere künstliche Neuronen Anwendung in finden, z. B. das High-Order-Neuron. Die Topologie eines Netzes (die Zuordnung von Verbindungen zu Knoten) muss der Aufgabe angemessen sein.

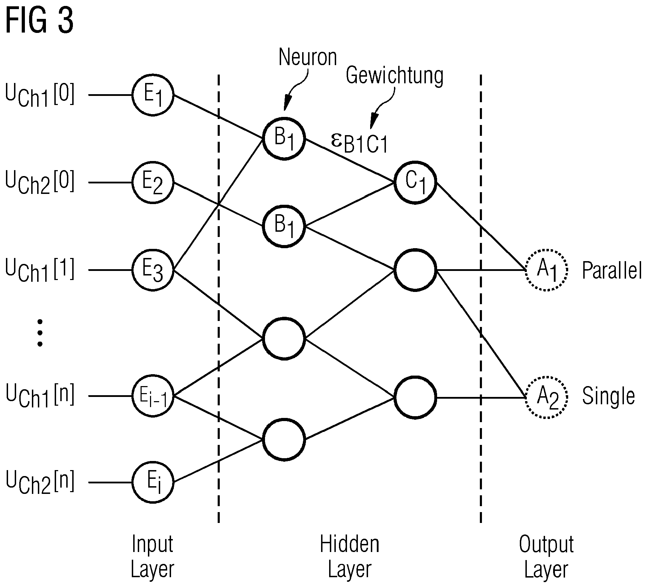

Wie in Fig. 3 beispielhaft dargestellt, wird beim vorliegenden Ausführungsbeispiel ein sogenanntes mehrschichtiges feedforward-Netz angewendet, welches neben Ein- und Ausgabeschicht Input Layer E1, E2... bzw. Output Layer A1, A2 auch verdeckte Schichten Hidden layers B1 .., C1 .. umfasst, deren Ausgaben außerhalb des Netzes nicht sichtbar sind. Bei feedforward-Netzen ist eine Schicht immer nur mit der nächsthöheren Schicht verbunden. Verdeckte Schichten verbessern die Abstraktion des Netzes.

Die Anzahl der Neuronen im Eingangslayer E1, E2... entspricht der Anzahl der Samples des Analog-Digital-Konverters. Die Anzahl der Neuronen im Ausgangs-Layer A1, A2 entspricht der Zahl an möglichen Ergebnissen, also "Parallel" bzw. "Single" bzw. der Aussage Parallelschaltung Ja/Nein.

Nach der Konstruktion eines Netzes folgt die Trainingsphase, in der das Netz "lernt", hauptsächlich durch Modifikation der Gewichte der Neuronen.

Das Training des neuronalen Netzes läuft rechnergestützt mittels üblicher Programme ab. Hierfür eignen sich spezialisierte Softwareprogramme wie TensorflowLite, Keras, Lasagne, Caffe, ONNX, Matlab, etc. Jede Software liefert als Ergebnis des Trainingsprozesses eine Datei, welches das funktionsfähige neuronale Netz enthält.

Wie aus Fig. 3 ersichtlich, sind die einzelnen Neuronen zwischen den Layern durch Gewichtungen $\varepsilon_{B1C1}$ verbunden. Dabei wird "ein Weg" durch das Netz gesucht und durch eine sogenannte Aktivierungsfunktion beschrieben die beispielsweise wie folgt lautet:

$$(E1\varepsilon_{E_1B_1}+E3\varepsilon_{E_3B_1}) + \; B1\varepsilon_{B_1C_1}+C1\varepsilon_{C_1A_1}$$

Während des Trainings wird dieser Pfad mit Initialisierungswerten für die Gewichtung durchlaufen. Durch Ausmultiplizieren und Addieren ergibt sich entlang des Pfads ein numerischer Wert für den ersten Ausgangsknoten A1. Dieser Vorgang wird Forward Propagation genannt. Da im Trainingsprozess der "wahre" Wert für den ersten Ausgangsknoten A1 bekannt ist wird die Abweichung vom Rechenergebnis zum tatsächlichen Wert ermittelt. Die Abweichung, bzw. der Fehler, gibt Aufschluss darüber, wie die Gewichtungsfaktoren neu gewichtet werden müssen. Dabei wird der Pfad vom ersten Ausgangsknoten A1 ausgehend zurückgerechnet. Dieser Vorgang wird Back Propagation genannt.

Dieser Vorgang wird so lange wiederholt, bis die Fehler möglichst gering für alle Fälle der Eingangstensoren abgebildet werden. Da dieser Optimierungsverlauf theoretisch endlos laufen würde, wird zweckmäßigerweise beim Training vorgeben, wie viele Durchläufe, Epochen genannt, stattfinden sollen. Durch Beobachtung der Fehlerrate von Epoche zu Epoche kann man erkennen, ob ein Modell ausreichend trainiert wurde.

Für das Training werden die zur Verfügung stehenden Daten vorzugsweise in Training-, Validierungs- und Testdaten aufgeteilt, wobei beispielsweise 60% der Daten für das reine Training herangezogen werden und 20% der Validierung des Modells dienen, sodass Anomalien in den Daten festgestellt werden können. Hierdurch soll bspw. verhindert werden, dass statistische Abweichungen in den Daten überbewertet werden.

Schließlich dienen 20% der Daten zum Testen des Netzwerks. Damit steht ein bekannter Datensatz zur Verfügung, den das Modell im Training nie gesehen hat und zur Überprüfung genutzt werden kann, ob das neuronale Netzwerk auch mit neuen Datensätzen plausible Ergebnisse liefert.

Die nun vorliegende Datei mit dem funktionsfähigen neuronalen Netz wird daraufhin in ein für die Überwachungseinrichtung der Stromversorgung - einen Mikrocontroller - verwendbares Format konvertiert.

Dies geschieht i.A. durch Übersetzung in ein HEX-File, das sich anschließend in den Sourcecode des Mikrocontrollers wie eine beliebige Programmierbibliothek (model.h und model.c) mit entsprechenden Parametern und Handlern einbinden lässt.

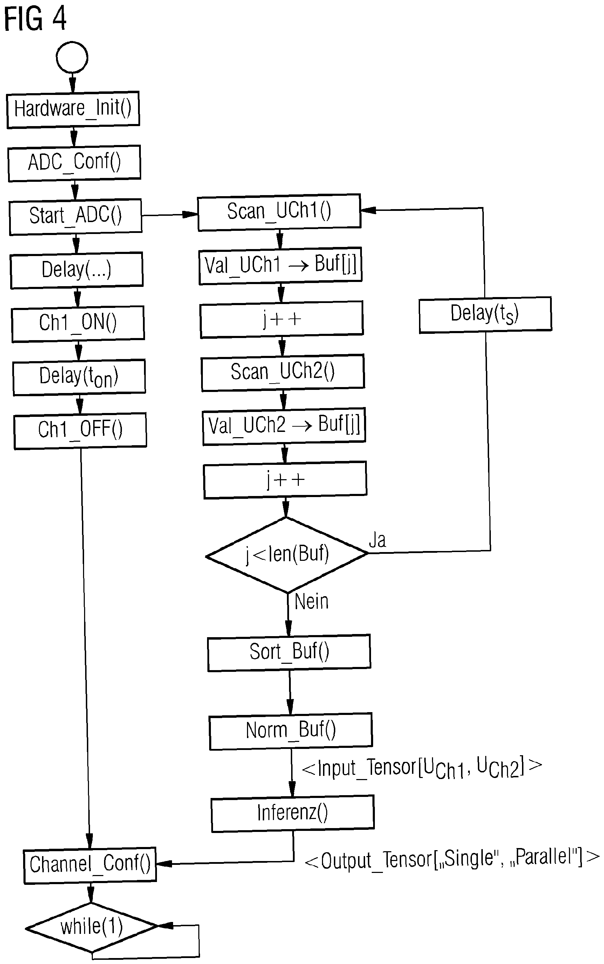

Der Ablauf des erfindungsgemäßen Verfahrens zur Erkennung von Parallelschaltungen während des Gerätehochlaufs in der Überwachungseinrichtung ist in Fig. 4 dargestellt.

Zunächst wird die Hardware initialisiert Hardware_Init(). Dabei werden bspw. die Taktfrequenz festgelegt und die Konfiguration der Peripherie des Mikrocontrollers vorgenommen. Anschließend wird im Schritt ADC_Conf() der Analog-Digital-Konverter für die Abtastung der Ausgangsspannungen vorbereitet. Hierbei wird die Länge des Buffers d.h. die Anzahl der Speicherplätze j festgelegt, bzw. die Abtastzeit ts bestimmt. Die Konfiguration muss so abgestimmt sein, dass genügend Samples während der Testsequenz für den Betriebseinsatz gesammelt werden. Die Anzahl der Samples n , bzw. die Buffer-Länge j muss gleich sein wie bei den Trainingsdaten. Weiters wird der Analog-Digital-Konverter so eingestellt, dass das Samplen der Daten zeitlich parallel zum Hauptprozess der Steuerung arbeitet. Dies wird durch Direkt-Memory Access ermöglicht.

Nach der Konfiguration wird der Analog-Digital-Konverter getriggert Start_ADC(). Der Abtastvorgang des Analog-Digital-Konverters beginnt und läuft parallel zur Testsequenz. Die Testsequenz kann optional auch etwas zeitverzögert starten, um auf hardwarebedingte Gegebenheiten achten zu können (Delay(...)). Anschließend wird der Kanal eingeschaltet (Ch1_ON()) und nach einer Einschaltzeit ton von typisch einigen 100$\mu$s (Delay(ton)) wird der Kanal 1 wieder abgeschaltet (Ch1_OFF()). Während der gesamten Testsequenz werden über den Abtastvorgang des Analog-Digital-Konverters beide Ausgangskanäle überwacht.

Nach der Triggerung des Analog-Digital-Konverters mittels Start_ADC() wird der erste Wert der Ausgangsspannung von Kanal 1 ermittelt (Scan_UCh1()) und in den ersten Speicherplatz des Buffers ( Val_UCh1 → Buf[ j ]) geschrieben, woraufhin die Speicherstelle erhöht wird (j++). Anschließend wird der erste Wert der Ausgangsspannung von Kanal 2 ermittelt (Scan_UCh2()) und in die zweite Speicherzelle des Buffers geschrieben (Val_UCh2 → Buf[ j ]). Anschließend wird die Speicheradresse wiederum erhöht (j++). Dieser Vorgang wird so lange wiederholt, bis der Buffer vollständig gefüllt ist, wobei der Abtastvorgang zu den vorhin eingestellten Abtastzeitpunkten ts erfolgt (Delay(ts)).

Sobald der Buffer vollgeschrieben wurde, werden die Daten nachbearbeitet. Wenn die Reihenfolge der Werte der Ausgangsspannung von Kanal 1 und Kanal 2 nicht mit der Reihenfolge in den Trainingsdaten übereinstimmen, oder auf zwei unterschiedlichen Analog-Digital-Konverter Peripherien gesampelt wird, müssen die Daten sortiert werden (Sort_Buf()). Anschließend folgt dieselbe Normierung wie bei den Trainingsdaten (Norm_Buf()). Da die Werte vom Analog-Digital-Konverter als 10Bit Integer Werte vorliegen, ist eine Normierung durch 1024 zweckmäßig. Bei 12Bit Auflösung wäre der Normierungsfaktor respektive 4096. Nach der Sortierung und Normierung liegt der Eingangstensor vor, sodass die Inferenz durchgeführt werden kann. Als Ergebnis erhält man den Ausgangstensor mit der Vorhersage, ob eine Parallelschaltung der Kanäle vorliegt oder nicht.

Auf Grund dieser Information kann die Überwachungseinrichtung die Konfiguration der Kanäle vornehmen (Channel_Conf()). Dadurch lassen sich für den weiteren Programmverlauf die Parameter für einen Parallelbetrieb anpassen. Dazu gehören insbesondere die Stromaufteilung der Kanäle, Anpassung der Auslösekennlinie, Begrenzungszeiten, Hochlaufverhalten.

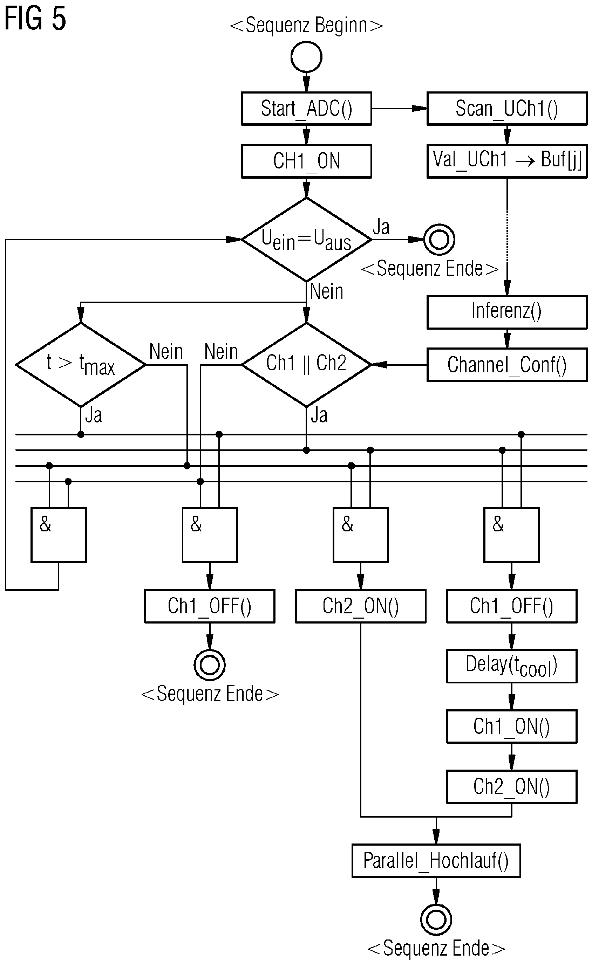

Die Integration des Verfahrens zur Erkennung von Parallelschaltungen von Ausgangskanälen in den Hochlauf einer Stromversorgungseinrichtung wird anhand der Fig. 5 erläutert.

Hierbei werden keine eigenen Testsequenzen benötigt und eine Parallelschaltung wird während des Hochlaufs von Kanal 1 erkannt. Dabei wird der Kanal 1 eingeschaltet und eine maximale Einschaltdauer tmax vorgegeben. Zeitgleich werden alle notwendigen Schritte gestartet, um eine Inferenz zur Parallelschaltungserkennung ausführen zu können, welche ggf. eine Parallelschaltung eines weiteren Kanals erkennt. Dies bedeutet, dass sich während des Hochlaufs von Kanal 1 der Ausgangszustand der Kanalkonfiguration ändern kann. Dadurch ergeben sich folgende Szenarien:

a) Es liegt keine Parallelschaltung vor und der Kanal 1 läuft innerhalb der maximalen Anlaufzeit tmax hoch. Dabei bleibt Kanal 1 eingeschaltet und es sind keine weiteren Schritte notwendig. Hierfür ist ein eigenes Abbruchkriterium notwendig, welches durch das Erreichen der Ausgangsspannung Uaus des Wertes, unter Berücksichtigung einer vorgebbaren Differenz, der Eingangsspannung Uein bestehen kann. Ferner ist auch durch Beobachtung des Ausgangsstroms ein hinreichendes Kriterium zu erreichen.

b) Es liegt keine Parallelschaltung vor, Kanal 1 läuft nicht innerhalb von tmax hoch und wird wieder abgeschaltet und verbleibt in diesem Zustand.

c) Eine Parallelschaltung von Kanal 1 und 2 liegt vor und wird innerhalb der maximalen Anlaufzeit tmax erkannt. Dabei wird der Kanal 2 zugeschaltet und der Anlauf erfolgt mit zwei parallelen Kanälen.

d) Eine Parallelschaltung von Kanal 1 und 2 liegt vor, wird aber erst nach Ablauf von tmax (oder es ist nicht genug Restzeit von Kanal 1 vorhanden, da dieser bereits auch für einen Parallelanlauf zu heiß ist) erkannt. Dabei werden beide Kanäle abgeschaltet und nach einer Abkühlzeit tcool erfolgt ein paralleler Anlauf von Kanal 1 und 2.

Der Hochlauf der Stromversorgungseinrichtung verläuft dann in Abhängigkeit vom vorliegenden Szenario wie folgt: Nach dem Einschalten von Kanal 1 wird die Abbruchbedingung abgefragt, ob die Ausgangsspannung Uaus (nahezu) den Wert der Eingangsspannung Uein erreicht hat (Szenario a). Anschließend wird sowohl die Einschaltdauer überwacht, um zu verhindern, dass der Transistor von Kanal 1 zu heiß wird, als auch abgefragt, ob eine Parallelschaltung eines weiteren Kanals erkannt wurde. Diese Abfragen werden so lange wiederholt, bis entweder die maximale Einschaltdauer erreicht wird (Szenario b) und/oder eine Parallelschaltung erkannt wurde.

Wie vorhin beschrieben, benötigt das neuronale Netz eine gewisse Anzahl an Samples, um eine Parallelschaltung erkennen zu können. Da Kanal 1 sich bereits im Hochlauf befindet, wird sich bei einer Parallelschaltung auch die Ausgangsspannung an Kanal 2, analog wie bei der Ausführung mittels Testimpulsen, ändern und kann damit erkannt werden.

Wird die Parallelschaltung vor Erreichen der maximalen Einschaltdauer erreicht (Szenario c) wird Kanal 2 dazugeschaltet und es findet ein paralleler Hochlauf beider Kanäle statt. Wird die Parallelschaltung erst nach Ablauf der maximalen Einschaltdauer tmax erkannt, oder es bleibt nicht genug Zeit von Kanal 1 für einen parallelen Hochlauf übrig (Szenario d), wird der Kanal 1 abgeschaltet und nach Ablauf einer Abkühlzeit tcool findet ein paralleler Hochlauf der Kanäle statt.

Die Ausführungsbeispiele beschreiben den Einsatz des neuronalen Netzes lediglich für zwei Ausgangskanäle. Die Erfindung kann jedoch ohne Einschränkungen auf Anwendungsfälle mit einer nahezu beliebigen Zahl von Kanälen angewendet werden.

Weiterhin ist es möglich, für die Kanäle nicht nur einen Messwert, sondern beliebig viele Messwerte zu erfassen, und diese dann in den Eingangstensor zu schreiben.

Außerdem ist es auch denkbar, mehrere Inferenzen gleichzeitig auszuführen, sodass mehrere Kombinationen gleichzeitig ausgewertet werden. Auch ist ein serieller Ablauf von Inferenzen denkbar, um entweder dasselbe neuronale Netz für eine Erkennung von jeweils benachbarten Kanälen (1∥2 2∥3 3∥4) zu nutzen, und damit Speicherplatz in der Zielhardware zu sparen, oder mehrere unterschiedliche Inferenzen, um weiter Kombinationen zu erfassen. Schließlich können neuronale Netze auch auf die Erkennung mehrerer Zustände trainiert werden. Durch die Erweiterung des Ausgangstensors lassen sich auch alle Kombinationen der Ausgangskanäle abbilden (1∥2∥3 2∥4 1∥3∥4, etc).

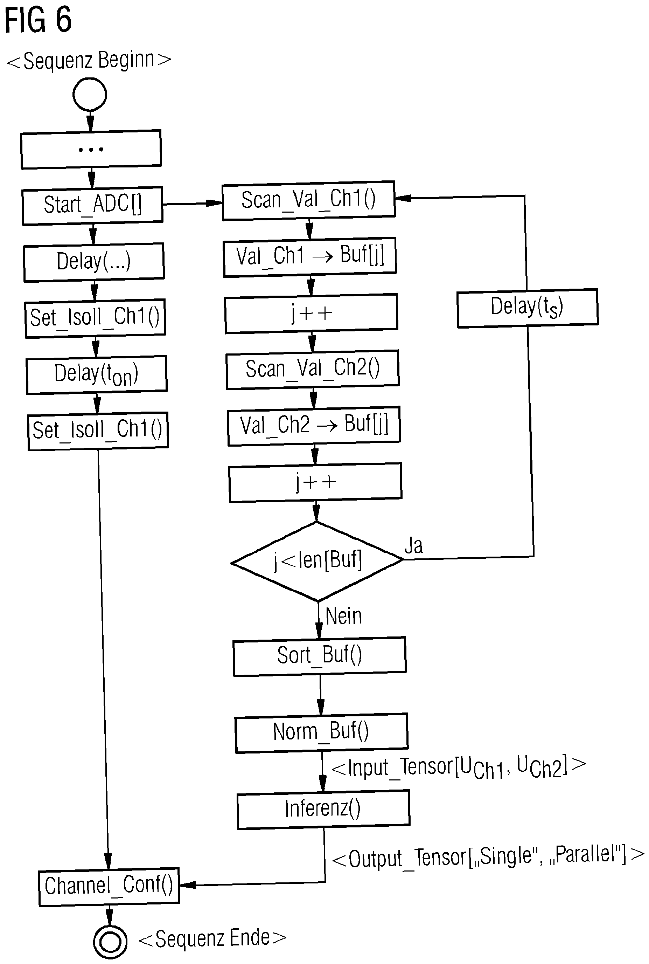

Das erfindungsgemäße Verfahren kann auch im laufenden Betrieb einer Stromversorgungseinrichtung eingesetzt werden. Ausserdem können anstelle der Spannungsverläufe auch die Ausgangsstromverläufe als Daten für das neuronale Netz herangezogen werden. Wird nun an einem Kanal kurzzeitig der Strom-Sollwert verändert dient entweder die Ausgangsspannung und/oder der Ausgangsstrom als Erkennungssignal einer Parallelschaltung. Fig. 6 zeigt den Ablauf im Betrieb als Sequenz innerhalb eines Programmablaufs im Sourcecode des μC. Dabei kann dies fortlaufend ein Teil des Hauptprogramms sein, als auch ein zyklisch aufgerufenes Hilfsprogramm. Der Vorgang wird durch die Triggerung des Analog-Digital-Konverters gestartet, wobei der Scanvorgang des Analog-Digital-Konverters parallel zur Testsequenz ausgeführt wird. Durch die Veränderung des Sollwerts Set_IsollCh1() unter den aktuellen Wert des Laststroms wird der Strom im Kanal zurückgeregelt. Daraufhin wird entweder die Spannung am Ausgang geringer oder der Strom wird von einem parallelgeschalteten Kanal übernommen. Ein neuronales Netz kann nun so trainiert werden, dass sowohl durch die Spannungsänderung am Ausgang, sofern diese an beiden Kanälen auftritt, als auch durch die Stromänderung in den Kanälen, erkannt werden kann. Nach einer gewissen Testdauer (Delay(ton)) von einigen 100ps bis wenigen ms (oder ggf. auch länger, sofern ein stabiler Betrieb nicht gefährdet wird) wird der Sollwert von Kanal 1 wieder angepasst und somit der reguläre Betrieb wieder hergestellt. Zeitgleich wird über den Analog-Digital-Konverter die Ausgangsspannung und/oder der Ausgangsstrom beider Kanäle überwacht. Nach Triggerung des Analog-Digital-Konverters wird wiederum der erste Messwert des Kanal 1 erfasst (Scan_Val_Ch1()) und in einen Buffer geschrieben (Val_Ch1 → Buf[ j ]). Nachdem die Speicherstelle (j++) erhöht wird, wird der Messwert an Kanal 2 erfasst (Scan-Val_Ch2()) und in den Buffer (Val_Ch2 → Buf[ j ]) geschrieben. Nachdem wiederum die Speicheradresse des Buffers (j++) erhöht wurde, wird der gesamte Vorgang mit der Samplerate ts (Delay(ts)) wiederholt bis der Buffer voll ist. Anschließend werden die Messwerte ggf. sortiert (Sort_Buf()) und normiert (Norm_Buf), woraufhin die Inferenz (Inferenz()) durchgeführt wird. Wird dabei eine Parallelschaltung der Kanäle erkannt, werden diese entsprechend konfiguriert und die zugehörigen Parameter angepasst (Channel_Conf()).

Bei der Einbindung der Parallelschaltungserkennung in die Abarbeitung des Hauptprogramms der Überwachungseinrichtung wird nicht mittels eines Prüfablaufs auf das Vorhandensein einer Parallelschaltung getestet, sondern in der Laufzeit des Programms, durch die ohnehin ermittelten Messwerte.

In der Hauptschleife des Programms der Überwachungseinrichtung werden ohnedies die Messwerte der Ausgangsgrößen ermittelt, um in einem Fehlerfall wie beim Auftreten von Überströmen oder einem Kurzschluss, etc. entsprechend reagieren zu können. Dabei werden die Messwerte nicht nach jedem Durchlauf wieder verworfen, sondern in den Buffer geschrieben. Sind genügend Werte gesammelt, um einen Eingangstensor für das neuronale Netz zu bilden, wird eine Inferenz durchgeführt und bei Erkennen einer Parallelschaltung werden die Kanäle entsprechend konfiguriert und parametrisiert. Es sei darauf hingewiesen, dass für diese Ausführung wiederum das gesamte Verfahren bestehend aus den Schritten 1...5 mit den dafür notwendigen Anpassungen durchlaufen werden muss.

Es ist auch denkbar, die Parallelschaltung von mehreren Geräten, also einen Verbund von elektronischen Sicherungen zu erkennen. Wenn das speisende oder die speisenden Netzgeräte ihre Ausgangsspannung variieren, geschieht dies im selben Maße an den Eingängen parallel geschalteter elektronischen Sicherungen. Die Eingangsspannung der elektronischen Sicherung wird ohnehin überwacht. Bei entsprechend ausgestatteten Gerätefamilien können über einen Kommunikationsbus Informationen ausgetauscht werden. Eines der Geräte könnte als Master im Verbund definiert werden, auf welchem die Inferenz durchgeführt wird.

## Patentansprüche

1. Verfahren zur Erkennung von Parallelschaltungen von Ausgangskanälen in Stromversorgungseinrichtungen, **dadurch gekennzeichnet, dass** zur Erkennung der Parallelschaltungen ein in einem ersten Digitalrechner einer Überwachungseinrichtung implementiertes neuronales Netz vorgesehen ist, dass zur Ermittlung von Trainingsdaten für das neuronale Netz in einer Stromversorgungseinrichtung verschiedene Betriebszustände ausgelöst und die dazugehörigen Spannungsverläufe ($U_{outCh1}$, $U_{outCh2}$) und/oder Stromverläufe an den Ausgangskanälen gemessen werden, dass die Trainingsdaten ($UCh1[0]$ $UCh2[1]$ $UCh1[2]$ $UCh2[3]$ ... $UCh1[j$ -3$]$ $UCh2[j$ - 2$]UCh1[j$ -1$]$ $UCh2[jj])$ an einen weiteren Digitalrechner übermittelt werden mittels welchem das Training des neuronalen Netzes erfolgt und dass das trainierte einsatzbereite neuronale Netz in den ersten Digitalrechner der Überwachungseinrichtung implementiert und zur Erkennung von Parallelschaltungen herangezogen wird.

2. Verfahren nach Anspruch 1, **dadurch gekennzeichnet, dass** die Stromversorgungseinrichtung einen eingangsseitig mit Ausgangskanälen der Stromversorgungseinrichtung und ausgangsseitig mit der Überwachungseinrichtung verbundenen Analog-Digital-Konverter umfasst.

3. Verfahren nach Anspruch 2, **dadurch gekennzeichnet, dass** zur Ermittlung von Trainingsdaten für das neuronale Netz in einer Stromversorgungseinrichtung verschiedene Betriebszustände mit verschiedenen Lastbedingungen mit und ohne Parallelschaltung ausgelöst werden, dass die Ausgangsspannungen an den Kanälen ($U_{outCh1}$, $U_{outCh2}$)

gemessen werden, mittels Analog-Digital-Konverter digitalisiert und in einem Speicher des Digitalrechners der Überwachungseinrichtung als Trainingsdaten($UCh1[0]$ $UCh2[1]$ $UCh1[2]$ $UCh2[3]$ ... $UCh1[j-3]$ $UCh2[j-2]UCh1[j-1]$ $UCh2[j]$) abgelegt werden.

4.  Verfahren nach Anspruch 3, **dadurch gekennzeichnet, dass** die Übertragung der digitalisierten Daten vom Analog-Digital-Konverter in einen Speicher des Digitalrechners der Überwachungseinrichtung mittels Direct-Memory-Access erfolgt.

5.  Verfahren nach einem der Ansprüche 1 bis 4, **dadurch gekennzeichnet, dass** als neuronales Netz ein mehrschichtiges feedforward-Netz angewendet wird, welches neben einer Ein- und einer Ausgabeschicht (Input Layer; Output Layer) auch verdeckte Schichten (Hidden layers) umfasst.

6.  Verfahren nach einem der Ansprüche 1 bis 5, **dadurch gekennzeichnet, dass** die zur Verfügung stehenden Trainingsdaten in Kerntrainings-, Validierungs- und Testdaten aufgeteilt werden, dass annähernd 60% der Trainingsdaten für das eigentliche Training herangezogen werden, dass 20% der Trainingsdaten zur Validierung des Modells und weitere 20% zum Testen des Netzwerks herangezogen werden.

7.  Verfahren nach einem der Ansprüche 1 bis 5, **dadurch gekennzeichnet, dass** die Ermittlung von Trainingsdaten für das neuronale Netz durch eine weitere, von der Überwachungseinrichtung unabhängige Hardware erfolgt.

## FIG 1A

U_out Ch1

U_out Ch2

Scan ADC

$t_0$  $t_1$  $t_2$  $t_3$

## FIG 1B

U_out Ch1

U_out Ch2

Scan ADC

$t_0$  $t_1$  $t_2$  $t_3$

## FIG 2A

U_out Ch1

U_out Ch2

Scan ADC

$t_0$  $t_1$  $t_2$  $t_3$

## FIG 2B

U_out Ch1

U_out Ch2

Scan ADC

$t_0$  $t_1$  $t_2$  $t_3$

## FIG 3

# FIG 4

Hardware_Init()

ADC_Conf()

Start_ADC() → Scan_UCh1()

Delay(...)

Ch1_ON()

Delay($t_{on}$)

Ch1_OFF()

Val_UCh1 → Buf[j]

j++

Scan_UCh2()

Val_UCh2 → Buf[j]

j++

Delay($t_S$)

$j < len(Buf)$ — Ja / Nein

Sort_Buf()

Norm_Buf()

$<Input\_Tensor[U_{Ch1}, U_{Ch2}]>$

Inferenz()

$<Output\_Tensor[„Single", „Parallel"]>$

Channel_Conf()

while(1)

# FIG 5

\<Sequenz Beginn\>

Start_ADC() → Scan_UCh1()

CH1_ON

Val_UCh1 → Buf[j]

$U_{ein}=U_{aus}$ — Ja → \<Sequenz Ende\>

Nein

Inferenz()

Channel_Conf()

t > $t_{max}$ — Nein — Nein — Ch1 || Ch2

Ja

&

&

Ch1_OFF()

\<Sequenz Ende\>

&

Ch2_ON()

&

Ch1_OFF()

Delay($t_{cool}$)

Ch1_ON()

Ch2_ON()

Parallel_Hochlauf()

\<Sequenz Ende\>

# FIG 6

\<Sequenz Beginn\>

```
        ◯
        │
        ▼
   ┌─────────┐
   │   ...   │
   └─────────┘
        │
        ▼
   ┌─────────────┐        ┌──────────────────┐
   │ Start_ADC[] │───────▶│  Scan_Val_Ch1()  │◀────────────┐
   └─────────────┘        └──────────────────┘             │
        │                         │                        │
        ▼                         ▼                        │
   ┌─────────────┐        ┌──────────────────┐             │
   │  Delay(...) │        │ Val_Ch1 → Buf[j] │             │
   └─────────────┘        └──────────────────┘             │
        │                         │                   ┌──────────────┐
        ▼                         ▼                   │  Delay(tS)   │
   ┌─────────────────┐    ┌──────────────────┐        └──────────────┘
   │ Set_Isoll_Ch1() │    │       j++        │             ▲
   └─────────────────┘    └──────────────────┘             │
        │                         │                        │
        ▼                         ▼                        │
   ┌─────────────────┐    ┌──────────────────┐             │
   │  Delay(ton)     │    │  Scan_Val_Ch2()  │             │
   └─────────────────┘    └──────────────────┘             │
        │                         │                        │
        ▼                         ▼                        │
   ┌─────────────────┐    ┌──────────────────┐             │
   │ Set_Isoll_Ch1() │    │ Val_Ch2 → Buf[j] │             │
   └─────────────────┘    └──────────────────┘             │
        │                         │                        │
        │                         ▼                        │
        │                 ┌──────────────────┐             │
        │                 │       j++        │             │
        │                 └──────────────────┘             │
        │                         │                        │
        │                         ▼                        │
        │                    ◇─────────────◇     Ja        │
        │                   ╱  j<len[Buf]   ╲──────────────┘
        │                    ◇─────────────◇
        │                         │ Nein
        │                         ▼
        │                 ┌──────────────────┐
        │                 │    Sort_Buf()    │
        │                 └──────────────────┘
        │                         │
        │                         ▼
        │                 ┌──────────────────┐
        │                 │    Norm_Buf()    │
        │                 └──────────────────┘
        │                         │ \<Input_Tensor[UCh1, UCh2]\>
        │                         ▼
        │                 ┌──────────────────┐
        │                 │    Inferenz()    │
        │                 └──────────────────┘
        │                         │
        │   \<Output_Tensor[„Single", „Parallel"]\>
        ▼                         │
   ┌──────────────────┐           │
   │  Channel_Conf()  │◀──────────┘
   └──────────────────┘
        │
        ▼
       ◎   \<Sequenz Ende\>
```

$\langle$Input_Tensor$[U_{Ch1}, U_{Ch2}]\rangle$

$\langle$Output_Tensor$[$„Single", „Parallel"$]\rangle$

**Europäisches Patentamt**
**European Patent Office**
**Office européen des brevets**

## EUROPÄISCHER RECHERCHENBERICHT

Nummer der Anmeldung

**EP 22 20 9307**

### EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | JP 2007 028837 A (FUJI ELECTRIC SYSTEMS CO LTD) 1. Februar 2007 (2007-02-01) * Anspruch 1 * ----- | 1-7 | INV. G01R19/25 |
| A | CN 113 131 725 A (UNIV ANHUI) 16. Juli 2021 (2021-07-16) * Absatz [0052]; Abbildung 3 * ----- | 1-7 | |
| A | US 2019/138072 A1 (KUROI YOSHIHIRO [JP]) 9. Mai 2019 (2019-05-09) * Anspruch 7 * ----- | 1-7 | |
| A | US 5 796 631 A (IANCU DANIEL S [US] ET AL) 18. August 1998 (1998-08-18) * Anspruch 3 * ----- | 1-7 | |
| A | US 2022/255153 A1 (KIM JEONG WAN [KR]) 11. August 2022 (2022-08-11) * Ansprüche 1,3 * ----- | 1-7 | |
| A | EP 2 624 398 A1 (SIEMENS AG [DE]) 7. August 2013 (2013-08-07) * Anspruch 1 * ----- | 1-7 | **RECHERCHIERTE SACHGEBIETE (IPC)** G01R G06N |
| A | US 2020/003659 A1 (DAVIES PETER GARETH [GB] ET AL) 2. Januar 2020 (2020-01-02) * Absatz [0250]; Anspruch 1 * ----- | 1-7 | |

Der vorliegende Recherchenbericht wurde für alle Patentansprüche erstellt

| Recherchenort | Abschlußdatum der Recherche | Prüfer |
|---|---|---|
| München | 30. Mai 2023 | Meliani, Chafik |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument

...............................................................................
& : Mitglied der gleichen Patentfamilie, übereinstimmendes Dokument

EPO FORM 1503 03.82 (P04C03)

**EP 4 375 680 A1**

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

30-05-2023

| Im Recherchenbericht angeführtes Patentdokument | Datum der Veröffentlichung | Mitglied(er) der Patentfamilie | Datum der Veröffentlichung |
|---|---|---|---|
| JP 2007028837 A | 01-02-2007 | KEINE | |
| CN 113131725 A | 16-07-2021 | CN 113131725 A | 16-07-2021 |
| | | CN 114759767 A | 15-07-2022 |
| US 2019138072 A1 | 09-05-2019 | CN 109753467 A | 14-05-2019 |
| | | JP 2019087089 A | 06-06-2019 |
| | | TW 201935180 A | 01-09-2019 |
| | | US 2019138072 A1 | 09-05-2019 |
| US 5796631 A | 18-08-1998 | KEINE | |
| US 2022255153 A1 | 11-08-2022 | CN 113631938 A | 09-11-2021 |
| | | EP 3936879 A1 | 12-01-2022 |
| | | JP 7170904 B2 | 14-11-2022 |
| | | JP 2022526136 A | 23-05-2022 |
| | | KR 20210039706 A | 12-04-2021 |
| | | US 2022255153 A1 | 11-08-2022 |
| | | WO 2021066394 A1 | 08-04-2021 |
| EP 2624398 A1 | 07-08-2013 | CN 104081613 A | 01-10-2014 |
| | | EP 2624398 A1 | 07-08-2013 |
| | | EP 2812969 A1 | 17-12-2014 |
| | | RU 2014132382 A | 10-04-2016 |
| | | US 2015008892 A1 | 08-01-2015 |
| | | WO 2013117384 A1 | 15-08-2013 |
| US 2020003659 A1 | 02-01-2020 | CN 110622013 A | 27-12-2019 |
| | | EP 3589962 A1 | 08-01-2020 |
| | | GB 2560032 A | 29-08-2018 |
| | | JP 2020514893 A | 21-05-2020 |
| | | KR 20190131046 A | 25-11-2019 |
| | | SG 11201907912Y A | 27-09-2019 |
| | | US 2020003659 A1 | 02-01-2020 |
| | | WO 2018158570 A1 | 07-09-2018 |

EPO FORM P0461

Für nähere Einzelheiten zu diesem Anhang : siehe Amtsblatt des Europäischen Patentamts, Nr.12/82

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 2812969 B1